# EUROPEAN PATENT APPLICATION

(11) **EP 4 749 316 A1**
(43) Date of publication of application: **27.05.2026**
(21) Application number: 24214791.6
(22) Date of filing: 22.11.2024
(51) Int. Cl.: G01R 33/48, G01R 33/561

(54) **METHOD AND DEVICE FOR CONTROLLING AN MRI-SYSTEM**

(71) Applicant: Siemens Healthineers AG, 91301 Forchheim (DE)
(72) Inventor: Buonincontri, Guido, 50059 Vinci (IT); Liu, Wei, 91052 Erlangen (DE); Paul, Dominik, 91088 Bubenreuth (DE)
(74) Representative: Siemens Healthineers Patent Attorneys

(57) **Abstract**

The invention pertains to a method for controlling an MRI-system (1), comprising the steps:
- providing a TSE-kernel (K) designed for Turbo Spin Echo acquisition,
- providing a center-parameterset (PC) for the TSE-kernel (K) intended for acquiring data in the center of k-space (kc), wherein the center-parameterset (PC) comprises at least timing information for the TSE-kernel (K),
- providing an edge-parameterset (PE) for the TSE-kernel (K) intended for acquiring data at the edge of k-space (ke), wherein the edge-parameterset (PE) comprises at least timing information for the TSE-kernel (K),
- calculating a transition-function (T) for a continuous transition from the center-parameterset (PC) to the edge-parameterset (PE), wherein for a k-space-index according to the center of k-space (kc), the transition-function (T) corresponds to the center-parameterset (PC), for a k-space-index according to the edge of k-space (ke), the transition-function (T) corresponds to the edge-parameterset (PE) and for a k-space-index according to a k-space-position between the center of k-space (kc) and the edge of k-space (ke), the transition-function (T) is calculated based on a predefined transition-scheme,
- generating a pulse-sequence (PS) over multiple varying k-space-indexes, wherein the TSE-kernel (K) for a certain k-space-index is varied according to the transition-function (T) depending on the k-space-index,
- outputting the pulse-sequence (PS) to the MRI-system (1).

Furthermore, the invention describes a device, a control-unit and a magnetic resonance imaging system.

## Description

The invention describes a method and a device for controlling an MRI-system, a control-unit for a magnetic resonance imaging system and a magnetic resonance imaging system.

In magnetic resonance imaging (MRI), a procedure named "Turbo Spin Echo" (TSE) is used to speed up image acquisition of spin echoes. In TSE, one excitation block comprising RF signals and gradients, designated as "kernel", is applied and several echoes are recorded. For example, segmented turbo spin echo sequences (2D TSE, 3D TSE, SPACE) conventionally run the same echo train with identical timing multiple times. However, they acquire a different part of the k-space with each echo train. Usually, in segmented TSE, the same kernel is repeated multiple times, with a fixed fill-time between repetitions. In this context, the same kernel means that the kernel consists of the same RF shapes, gradient shapes and echo timings, regardless of the spatial encoding differences.

Especially in heavily weighted T2 imaging or 3D Acquisitions, the fill-time ("TRFill") between the execution of the different kernels is comparably long, leading to a long overall acquisition time. However, the effect or influence on the final image contrast is not identical from the different parts of the k-space. Mainly (or even only) the central part of k-space describes the contrast. While the outer part of the k-space describes the image sharpness.

It should be noted that in turbo spin echo, different echoes in the echo train (corresponding to different k-space coordinates) have different T2 weightings. Therefore, the sequence is optimized to use the most efficient parameters and k-space index orderings to achieve the requested contrast yet maximizing signal to noise ratio (SNR) and minimizing T2-related blurring. However, optimizations are limited to a single echo train which is run multiple times.

It is the object of the present invention to improve the known systems and methods and provide a method and a device for controlling an MRI-system, a control-unit for a magnetic resonance imaging system and a magnetic resonance imaging system, for overcoming the above described problems.

This object is achieved by a method according to claim 1, a device according to claim 10, a control-unit according to claim 12 and a magnetic resonance imaging system according to claim 13.

A method according to the invention serves for controlling an MRI-system. This means that the output of the method can be used for generating a pulse-sequence that can be used for MRI-imaging. The pulse-sequence could be applied to the coils of the MRI-system in order to produce RF-signals and magnetic signals. The method comprises the following steps:
- providing a TSE-kernel designed for Turbo Spin Echo acquisition,
- providing a center-parameterset for the TSE-kernel intended for acquiring data in the center of k-space, wherein the center-parameterset comprises at least timing information for the TSE-kernel,
- providing an edge-parameterset for the TSE-kernel intended for acquiring data at the edge of k-space, wherein the edge-parameterset comprises at least timing information for the TSE-kernel,
- calculating a transition-function for a continuous transition from the center-parameterset to the edge-parameterset, wherein for a k-space-index according to the center of k-space, the transition-function corresponds to the center-parameterset, for a k-space-index according to the edge of k-space, the transition-function corresponds to the edge-parameterset and for a k-space-index according to a k-space-position between the center of k-space and the edge of k-space, the transition-function is calculated based on a predefined transition-scheme,
- generating a pulse-sequence over multiple varying k-space-indexes, wherein the TSE-kernel for a certain k-space-index is varied according to the transition-function depending on the k-space-index,
- outputting the pulse-sequence to the MRI-system.

In the first step, a TSE-kernel is provided. A TSE-kernel is used to acquire a shot, consisting of predefined plurality of consecutive echoes as part of an echo train. A 3D single slab sequence acquires a series of such shots/kernels. A kernel includes the timing information, RF shapes, gradient moments and flip angles of the RF pulses used in the echo train. An exemplary TSE-kernel comprises an initial excitation RF-pulse followed by several refocusing RF-pulses. After any of the refocusing pulses, one echo can be recorded after its echo-time TE. Gradients applied together with the RF-pulses are used for k-space encoding.

It should be noted that the kernel itself is not the important part of the invention, but a special pattern generated from multiple different kernels applied in varying temporal lengths.

Before applying the kernels, a center-parameterset and an edge-parameterset for the TSE-kernel must be known. These parametersets are needed to configure the TSE-kernel for acquiring data. They define the composition of the TSE-kernels applied for acquiring data in the center of k-space (the center-parameterset) and at the edge of k-space (the edge-parameterset). In the state of the art, only one parameterset is used for the complete k-space and the same kernel is repeated multiple times to fill all the k-space indexes required to reconstruct an image. It should be noted that the term "parameterset" means the values of certain predefined parameters. It is clear that the values of both parametersets pertain to the same parameters in order to reflect the state at the center and at the edge.

The parametersets could be provided by a user (e.g. over a user interface) or be predefined (especially individually for given examinations). They could also be calculated, e.g. by using data of a patient to be examined. Thus, differently from the conventional sequence parameterization, one parameterization (the center-parameterset) is defined in the k-space center and a different one (the edge-parameterset) in the k-space edges. This could especially be done by selecting a target contrast in the k-space center, preferably dictated by the prescribed contrast information, and a target contrast in the k-space edges, again preferably dictated by a different set of parameter values. Contrast information / parameter values (the parametersets) at least comprise timing information for the TSE-kernel such as e.g. the echo time TE, repetition time TR, echo spacing or the individual flip angles of the excitation or the refocusing pulses.

It is said that the parametersets are intended for acquiring data, since until now, no data are acquired. However, the parametersets should be chosen such that suitable data for an intended examination could be acquired. Preferably, parameterizing different kernels independently includes (but is not limited to) changing the TR of each kernel repetition. As an example, a SPACE sequence could be implemented where the TR is changed cubically depending on the Z-coordinate of k-space (kz).

To cover all the regions between the k-space center and its edges, a continuous function is used: The transition-function. This function generates parametersets for k-space indexes between center and edge smoothly from the center-parameterset to the edge-parameterset (or the other way round) in the periphery of k-space. Thus, with the center-parameterset and the edge-parameterset, only two different kernels could be defined. With the transition-function, other kernels can be defined for acquiring further datapoints in k-space between the center and the edge. Typically, the transition-function is a mathematical function that is calculated in order to provide a continuous transition from the center-parameterset to the edge-parameterset. However, it could also be a list of parametersets or factors comprising values for every desired coordinate in k-space. For example, the transition-function might be a polynomial equation of degree 3, such as y = ax³ + bx² + cx + d, where x is the k-space-index. The coefficients a, b, c, and d are calculated based on the center- and edge-parametersets so that for an x in the center, y corresponds to the center-parameterset and for an x at the edge, y corresponds to the edge-parameterset.

As explained, the transition-function depends on the k-space-index that is a numerical value representing the position in k-space, i.e. the k-space coordinate. The transition-function follows a predefined transition-scheme that defines the general shape of the transition-function. The transition-scheme could be a polynomial such as a linear transition, a squared transition or a cubic transition (see example above, for a squared transition-scheme a = 0 and for a linear a = b = 0). However, other schemes such as a logarithmic, a reciprocal or an exponential scheme could also be advantageous for special applications.

A series of kernels, called a "pulse-sequence", is then generated to control the MRI system. In the pulse-sequence, the initial TSE-kernel (e.g. the TSE-kernel of the k-space-index according to the center of k-space) is varied according to the transition-function depending on the k-space-index. The k-space indexes associated with each receiver event are preferably defined by the MR pulse-sequence via a reordering method, which assigns a pair of (ky, kz) views to a (shot, echo) pair. For example, the pulse-sequence could comprise of a series of RF pulses with varying duration and preferably also varying amplitude, each corresponding to a specific k-space-index.

Thus, given a target contrast, different echo train lengths and timings for pulses in the parametersets, multiple, individually parameterized echo trains and timings could be measured by using the varying TSE-kernels within the same acquisition.

The generated pulse-sequence is then outputted to the MRI system for the application of corresponding RF-pulses and magnetic pulses (e.g. gradients) for an examination. It should be noted that it is not necessary that the pulse-sequence is applied immediately, it could also be saved as a dataset in a memory and be fed to an MRI-system later. Such dataset may also be applied several times for several examinations.

For image reconstruction, it is advantageous to know which measured data corresponds to which k-space index. Here, when using varying TSE-kernels it is preferred to record the order of the TSE-kernels (and the k-space-indexes) in form of a reordering-function. Such reordering-function (a k-space index reordering function or a TSE-kernel reordering function) could then be used to assign the correct echoes from the various echo trains to the target k-space indexes. The reordering method should, thus, be compatible with the variation of the TSE-kernel (having also influence on TR variation) in order to achieve a desired contrast in the k-space center and in the k-space periphery. However, knowing the parametersets and the transition-function, a reordering-function could also be determined from a given pulse-sequence. It is preferred that the reordering function is designed such that the correct echo time is in the k-space center and additionally orders echoes between the echo trains.

By using echo trains with different timings in distinct parts of k-space due to the application of varying TSE-kernels according to the invention, the recorded areas have different T1 and T2 blurring. Therefore, with the invention it is possible to trade-off between T2 and T1 blurring in different areas of k-space, prioritizing efficiency of signal to noise ratio (SNR) or contrast depending on the k-space location.

A device according to the invention for controlling an MRI-system comprises the following components:
- a kernel-unit designed for providing a TSE-kernel designed for Turbo Spin Echo acquisition,
- a parameter-unit designed for
   i) providing a center-parameterset for the TSE-kernel intended for acquiring data in the center of k-space, wherein the center-parameterset comprises at least timing information for the TSE-kernel, and
   ii) providing an edge-parameterset for the TSE-kernel intended for acquiring data at the edge of k-space, wherein the edge-parameterset comprises at least timing information for the TSE-kernel,
- a transition-unit designed for calculating a transition-function for a continuous transition from the center-parameterset to the edge-parameterset, wherein for a k-space-index according to the center of k-space, the transition-function corresponds to the center-parameterset, for a k-space-index according to the edge of k-space, the transition-function corresponds to the edge-parameterset and for a k-space-index according to a k-space-position between the center of k-space and the edge of k-space, the transition-function is calculated based on a predefined transition-scheme,
- a sequence-unit designed for generating a pulse-sequence over multiple varying k-space-indexes, wherein the TSE-kernel for a certain k-space-index is varied according to the transition-function depending on the k-space-index,
- a data-interface designed for outputting the pulse-sequence to the MRI-system.

The device is preferably designed for performing the method according to the invention. The function of the components of the device is described above.

The kernel-unit could be a software module responsible for providing a TSE-kernel designed for Turbo Spin Echo acquisition. The kernel-unit might be a software library comprising schemes for TSE-kernels for several applications.

The parameter-unit could comprise a memory module with a user interface, wherein some predefined pairs of parametersets (center-parametersets and edge-parametersets) could be present in the memory and it is possible to enter pairs of parametersets via the user interface manually. For example, the center-parameterset values such as repetition time = 1500ms, echo spacing = 5.5ms, refocusing flip angle 120°, and for the edge-parameterset values such as repetition time = 1000ms, echo spacing = 5.2ms, refocusing flip angle 100°, could be entered or be present in the memory.

The transition-unit is a software module responsible for calculating the transition-function from pairs of parametersets provided by the parameter-unit, e.g. that has been inputted by a user or retrieved from memory.

The sequence-unit is a software module responsible for generating a series of radiofrequency pulses. It could comprise a reordering-function and be designed to arrange the varying TSE-kernels according to this reordering-function. The multiple arranged TSE-kernels (e.g. together with fill-times and maybe additional gradients) then form the pulse-sequence. For example, the sequence-unit might generate a pulse-sequence comprising 256 TSE-kernels with varying amplitude and duration, each corresponding to a specific k-space-index.

The reordering-function could later be used to recognize the correct datasets of the measured raw data.

The data-interface could be a hardware or a software component responsible for transmitting the generated pulse-sequence to the MRI system for execution. The data-interface might be a databus, an ethernet cable or a wireless connection that sends the pulse-sequence to the MR-scanner. It could also be a software interface that enables the control device of an MR-scanner to access data for a pulse-sequence in a memory.

A control-unit according to the invention serves for a magnetic resonance imaging system. It comprises a device according to the invention and/or it is designed to perform a method according to the invention. It could be the central control device of an MRI-system or an additional control-unit used by or controlled with the central control device.

A magnetic resonance imaging system according to the invention comprises the control-unit according to the invention.

Some units or modules of the invention mentioned above can be completely or partially realized as software modules running on a processor of a computing system. A realization largely in the form of software modules can have the advantage that applications already installed on an existing computing system can be updated, with relatively little effort, to install and run these units of the present application. The object of the invention is also achieved by a computer program product with a computer program that is directly loadable into the memory of a computing system, and which comprises program units to perform the steps of the methods, at least those steps that could be executed by a computer, when the program is executed by the computing system. In addition to the computer program, such a computer program product can also comprise further parts such as documentation and/or additional components, also hardware components such as a hardware key (dongle etc.) to facilitate access to the software.

A computer readable medium such as a memory stick, a hard-disk or other transportable or permanently-installed carrier can serve to transport and/or to store the executable parts of the computer program product so that these can be read from a processor unit of a computing system. A processor unit can comprise one or more microprocessors or their equivalents.

Particularly advantageous embodiments and features of the invention are given by the dependent claims, as revealed in the following description. Features of different claim categories may be combined as appropriate to give further embodiments not described herein.

According to a preferred method, a fill-time between the TSE-kernels of the pulse-sequence is inserted to achieve variable TR, the temporal length of the fill-time depending on the transition-function. The timing and composition of each kernel can be chosen independently of the fill-time. It is also preferred that not (or not just) the timing of the kernel varies but also its composition, e.g. the list of flip angles or the echo train lengths. To parameterize the sequence, a user could choose a contrast in the k-space center and one in the k-space edges.

It is also preferred that the transition-scheme also comprises a certain fill-time for a TSE-kernel. This means that there are given pulse shapes and a general arrangement of pulses in the transition-scheme plus a certain fill-time following the exciting TSE-kernel.

Thus, according to a preferred method, the center-parameterset and the edge-parameterset additionally comprise parameter values concerning a list of flip angles and/or a temporal length of an echo train.

According to a preferred method, the transition-scheme is a polynomial such as linear, square, cubical or exponential scheme, preferably a variation of the repetition time (TR).

According to a preferred method, the pulse-sequence is a SPACE-sequence. This is a well-known sequence, that creates high spatial resolution three-dimensional datasets. The name "SPACE" is an abbreviation for "Sampling Perfection with Application optimized Contrast using different flip angle Evolution". The invention is very advantageous when combined with SPACE.

According to a preferred method, at least one further parameterset is provided at a different k-space-index than the center-parameterset and the edge-parameterset and the transition-function is calculated based on all provided parametersets and corresponds to these parametersets at the respective k-space-indexes.

According to a preferred method, a k-space index reordering function is provided or calculated, designed to assign correct echoes from echo trains obtained by the kernels of the pulse-sequence to the k-space indexes.

According to a preferred method, at least one contrast-parameter, especially a repetition-time (TR), is determined for each TSE-kernel depending on a k-space position. It is preferred that a value for this contrast-parameter is defined for a center-parameterset and for an edge-parameterset, e.g. a center repetition-time and an edge repetition-time is defined automatically or by a user or by a function. It is preferred that a continuous function is used as transition-function to define the contrast-parameter values, especially repetition-times, between the center-parameterset and the edge-parameterset.

According to a preferred method, the continuous function is a function of the k-space radius, especially of the Y-coordinate and/or Z-coordinate of k-space. In general, any envelope can be used for this purpose, as long as the central and edge TR boundary conditions are met.

A preferred device comprises a filltime-unit designed for inserting fill-times into the application scheme between the TSE-kernels of the pulse-sequence, and to determine the temporal length of the fill-times.

Other objects and features of the present invention will become apparent from the following detailed descriptions considered in conjunction with the accompanying drawings. It is to be understood, however, that the drawings are designed solely for the purposes of illustration and not as a definition of the limits of the invention.
Figure 1 shows a schematic representation of an MRI-system with a device according to the invention.
Figure 2 shows a pulse-train according to the prior art.
Figure 3 shows a pulse-train according to the invention.
Figure 4 shows different TR-envelopes in k-space.
Figure 5 shows a comparison of images acquired with a prior art method and with the invention.
Figure 6 shows a method for controlling an MRI-system according to the invention.

In the diagrams, like numbers refer to like objects through-out. Objects in the diagrams are not necessarily drawn to scale.

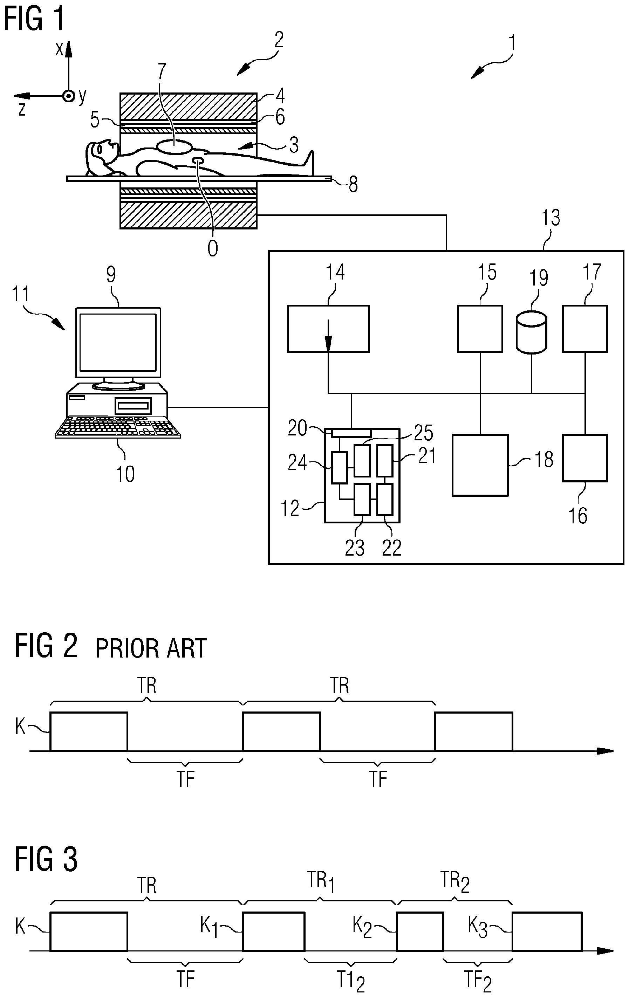

Figure 1 shows a schematic representation of a magnetic resonance imaging system 1 ("MRI-system" 1). The MRI system 1 includes the actual magnetic resonance scanner (data acquisition unit) 2 with an examination space 3 or patient tunnel in which a patient or test person is positioned on a driven bed 8, in whose body the actual examination object O is located.

The magnetic resonance scanner 2 is typically equipped with a basic field magnet system 4, a gradient system 6 as well as an RF transmission antenna system 5 and an RF reception antenna system 7. In the shown exemplary embodiment, the RF transmission antenna system 5 is a whole-body coil permanently installed in the magnetic resonance scanner 2, in contrast to which the RF reception antenna system 7 is formed as local coils (symbolized here by only a single local coil) to be arranged on the patient or test subject. In principle, however, the whole-body coil can also be used as an RF reception antenna system, and the local coils can respectively be switched into different operating modes.

The basic field magnet system 4 is designed so that MR-images can be recorded. It here is designed in a typical manner so that it generates a basic magnetic field in the longitudinal direction of the patient, i.e. along the longitudinal axis of the magnetic resonance scanner 2 that proceeds in the z-direction. The gradient system 6 typically includes individually controllable gradient coils in order to be able to switch (activate) gradients in the x-direction, y-direction or z-direction independently of one another.

The MRI system 1 shown here is a whole-body system with a patient tunnel into which a patient can be completely introduced. However, in principle the invention can also be used at other MRI systems, for example with a laterally open, C-shaped housing, as well as in smaller magnetic resonance scanners in which only one body part can be positioned.

Furthermore, the MRI-system 1 has a central control device 13 that is used to control the MRI system 1. This central control device 13 includes a sequence control-unit 14 for measurement sequence control. With this sequence control-unit 14, the series of radio-frequency pulses (RF pulses) and gradient pulses can be controlled depending on a selected pulse-sequence PS or, respectively, a series of multiple pulse-sequences PS to acquire multiple magnetic resonance images within a measurement session. For example, such a series of pulse-sequences PS can be predetermined within a measurement or control protocol. Different control protocols for different measurements or measurement sessions are typically stored in a memory 19 and can be selected by and operator (and possibly modified as necessary) and then be used to implement the measurement.

To output the individual RF pulses of a pulse-sequence PS, the central control device 13 has a radio-frequency transmission device 15 that generates and amplifies the RF pulses and feeds them into the RF transmission antenna system 5 via a suitable interface (not shown in detail). To control the gradient coils of the gradient system 6, the control device 13 has a gradient system interface 16. The sequence control-unit 14 communicates in a suitable manner with the radio-frequency transmission device 15 and the gradient system interface 16 to emit the pulse-sequence PS.

Moreover, the control device 13 has a radio-frequency reception device 17 (likewise communicating with the sequence control-unit 14 in a suitable manner) in order to acquire magnetic resonance signals (i.e. raw data) for the individual measurements, which magnetic resonance signals are received in a coordinated manner from the RF reception antenna system 7 within the scope of the pulse-sequence PS.

A reconstruction unit 18 receives the acquired raw data and reconstructs magnetic resonance image data therefrom for the measurements. This reconstruction is typically performed on the basis of parameters that may be specified in the respective measurement or control protocol. For example, the image data can then be stored in a memory 19.

Operation of the central control device 13 can take place via a terminal 10 with an input unit and a display unit 9, via which the entire MRI system 1 can thus also be operated by an operator. MR images can also be displayed at the display unit 9, and measurements can be planned and started by means of the input unit (possibly in combination with the display unit 9), and in particular suitable control protocols can be selected (and possibly modified) with suitable series of pulse-sequences PS as explained above.

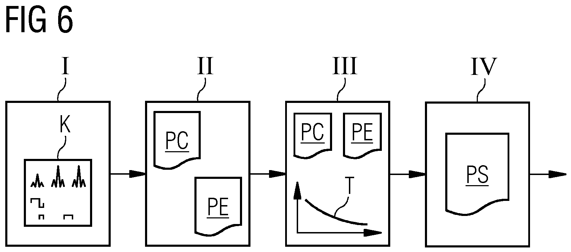

The control device 13 (in this example it is also the control-unit 13) comprises a device 12 for performing the method according to the invention. It comprises a kernel-unit 21, a parameter-unit 22, a transition-unit 23, a sequence-unit 24, a filltime-unit 25 and a data-interface 20 (see also figure 6 for the process).

The kernel-unit 21 is designed for providing a TSE-kernel K. This TSE-kernel K is designed for Turbo Spin Echo acquisition. The kernel-unit 21 could be a data interface for retrieving information for a kernel from a database or a software-module designed for generating TSE-kernels.

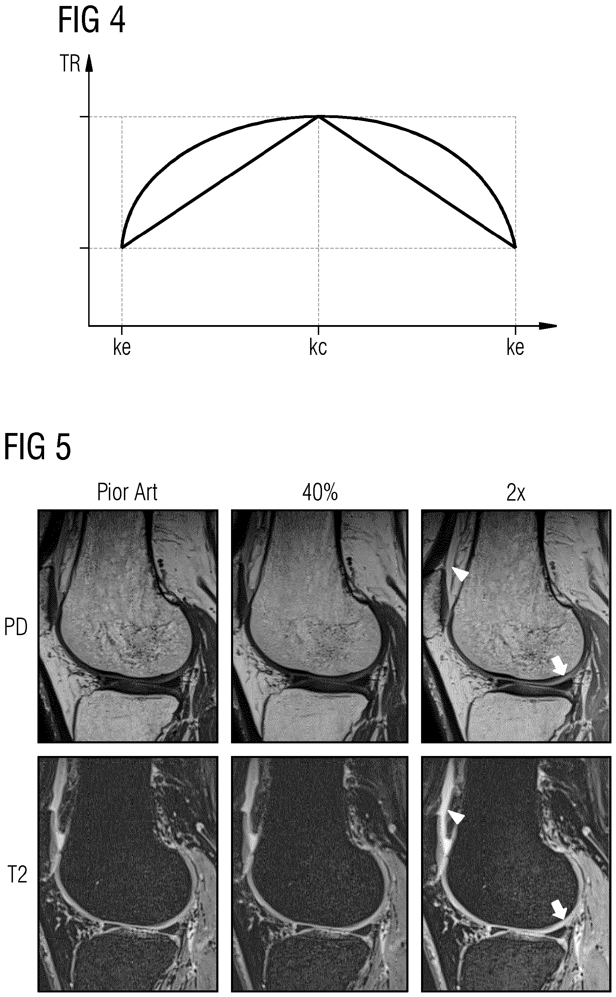

The parameter-unit 22 is designed for providing a center-parameterset PC and an edge-parameterset PE for the TSE-kernel K intended for acquiring data in the center of k-space kc and the edge of k-space ke (see figure 4). The parametersets PC, PE comprise at least timing information for the TSE-kernel K.

The transition-unit 23 is designed for calculating a transition-function T for a continuous transition from the center-parameterset PC to the edge-parameterset PE, wherein for a k-space-index according to the center of k-space kc, the transition-function corresponds to the center-parameterset PC, for a k-space-index according to the edge of k-space ke, the transition-function T corresponds to the edge-parameterset PE and for a k-space-index according to a k-space-position between the center of k-space kc and the edge of k-space ke, the transition-function T is calculated based on a predefined transition-scheme.

The sequence-unit 24 is designed for generating a pulse-sequence PS over multiple varying k-space-indexes, wherein the TSE-kernel K for a certain k-space-index is varied according to the transition-function T depending on the k-space-index.

The filltime-unit 25 is designed for inserting fill-times TF into the application scheme between the TSE-kernels K of the pulse-sequence PS, and to determine the temporal length of the fill-times TF.

The data-interface 20 is designed for outputting the pulse-sequence PS to the MRI-system 1 and to receive possible user commands inputted via a user interface on the terminal 10.

The MRI system 1 according to the invention, and in particular the control device 13, can have a number of additional components that are not shown in detail but are typically present at such systems, for example a network interface in order to connect the entire system with a network and be able to exchange raw data and/or image data or, respectively, parameter maps, but also additional data (for example patient-relevant data or control protocols).

The manner by which pulses and gradients are applied and suitable raw data are acquired by radiation of such pulses as well as how MR images are reconstructed from the raw data, is known to those skilled in the art and thus need not be explained in detail herein.

Figure 2 shows a pulse-train according to the prior art. It can be seen that all TSE-kernels K and fill-times TF are identical. The same TSE-kernel K is repeated multiple times, with a pause (fill-time TF) between repetitions resulting in identical repetition times TR. This pause is suboptimal, if in the specific application it is not possible to interleave slices in that time.

Figure 3 shows a pulse-train according to the invention. Here, the TSE-kernels K, K₁, K₂, K₃ and fill-times TF, TF₁, TF₂ are different. In the pulse-sequence PS, the TSE-kernel K, K₁, K₂, K₃ and the fill-time TF, TF₁, TF₂ is changed in every repetition. Thus, also the repetition times TR, TR₁, TR₂ are different.

Figure 4 shows different TR-envelopes in k-space. The upper one is an elliptical envelope, the lower one a linear. As shown in figure 3, the TSE-kernel K, and with it the repetition time TR, is changed depending on its k-space position. Here, the repetition-time TR is defined by the user in the center partition and in the edge partition, and a continuous function is used to define the repetition-time TR of the other partitions. Examples here include a linear TR-envelope as a function of kz (lower line), or an ellipsoidal TR-envelope (upper line). However, in general, any envelope can be used for this purpose, as long as the central and edge TR boundary conditions are met.

Figure 5 shows a comparison of images acquired with a prior art method and with the invention. Cubically changing repetition-time TR depending on the kz coordinate can help reduce the scan-time by over 40% at the expense of T1 blurring or increase the repetition-time TR in the center of k-space kc by a factor of 2 in the same scan time, to increase the PD weighting visible in the contrast fluid (arrowhead), or the cartilage contrast (arrow).

Figure 6 shows a method for controlling an MRI-system.

In step I, a TSE-kernel K is provided that is designed for Turbo Spin Echo acquisition. For the TSE-kernel K, RF-pulses (above) and gradients (below) are outlined.

In step II, a center-parameterset PC and an edge-parameterset PE for the TSE-kernel K are provided intended for acquiring data in the center of k-space kc and the edge of k-space ke (see figure 4), wherein the parametersets PC, PE comprise at least timing information for the TSE-kernel K.

In step III, a transition-function T is calculated for a continuous transition from the center-parameterset PC to the edge-parameterset PE, wherein for a k-space-index according to the center of k-space kc, the transition-function T corresponds to the center-parameterset PC, for a k-space-index according to the edge of k-space ke, the transition-function T corresponds to the edge-parameterset PE and for a k-space-index according to a k-space-position between the center of k-space kc and the edge of k-space ke, the transition-function T is calculated based on a predefined transition-scheme.

In step IV, a pulse-sequence PS is generated over multiple varying k-space-indexes, wherein the TSE-kernel K for a certain k-space-index is varied according to the transition-function T depending on the k-space-index.

This pulse-sequence PS is then outputted to an MRI-system 1, as e.g. shown in figure 1.

Although the present invention has been disclosed in the form of preferred embodiments and variations thereon, it will be understood that numerous additional modifications and variations could be made thereto without departing from the scope of the invention. For the sake of clarity, it is to be understood that the use of "a" or "an" throughout this application does not exclude a plurality, and "comprising" does not exclude other steps or elements. The expression "a number of" means "at least one". The mention of a "unit" or a "device" does not preclude the use of more than one unit or device. Independent of the grammatical term usage, individuals with male, female or other gender identities are included within the term.

## Claims

1. A method for controlling an MRI-system (1), comprising the steps:
- providing a TSE-kernel (K) designed for Turbo Spin Echo acquisition,
- providing a center-parameterset (PC) for the TSE-kernel (K) intended for acquiring data in the center of k-space (kc), wherein the center-parameterset (PC) comprises at least timing information for the TSE-kernel (K),
- providing an edge-parameterset (PE) for the TSE-kernel (K) intended for acquiring data at the edge of k-space (ke), wherein the edge-parameterset (PE) comprises at least timing information for the TSE-kernel (K),
- calculating a transition-function (T) for a continuous transition from the center-parameterset (PC) to the edge-parameterset (PC), wherein for a k-space-index according to the center of k-space (kc), the transition-function (T) corresponds to the center-parameterset (PC), for a k-space-index according to the edge of k-space (ke), the transition-function (T) corresponds to the edge-parameterset (PE) and for a k-space-index according to a k-space-position between the center of k-space (kc) and the edge of k-space (ke), the transition-function (T) is calculated based on a predefined transition-scheme,
- generating a pulse-sequence (PS) over multiple varying k-space-indexes, wherein the TSE-kernel (K) for a certain k-space-index is varied according to the transition-function (T) depending on the k-space-index,
- outputting the pulse-sequence (PS) to the MRI-system (1).

2. The method according to claim 1, wherein also a fill-time (TF) between the TSE-kernels (K) (K) of the pulse-sequence (PS) is inserted, the temporal length of the fill-time (TF) depending on the transition-function (T), preferably wherein the transition-scheme also comprises a certain fill-time (TF) for a TSE-kernel (K).

3. The method according to claim 1 or 2, wherein the center-parameterset (PC) and the edge-parameterset (PE) additionally comprise parameter values concerning a list of flip angles and/or a temporal length of an echo train.

4. The method according to one of the preceding claims, wherein the transition-scheme is a polynomial or exponential scheme, preferably a variation of a repetition time.

5. The method according to one of the preceding claims, wherein the pulse-sequence (PS) is a SPACE-sequence.

6. The method according to one of the preceding claims, wherein at least one further parameterset is provided at a different k-space-index than the center-parameterset (PC) and the edge-parameterset (PE) and the transition-function (T) is calculated based on all provided parametersets and corresponds to these parametersets at the respective k-space-indexes.

7. The method according to one of the preceding claims, wherein a k-space index reordering function is provided or calculated, designed to assign correct echoes from echo trains produced by the kernels of the pulse-sequence (PS) to the k-space indexes, preferably wherein the k-space index reordering function is derived from the generating of the pulse-sequence (PS) over the multiple varying k-space-indexes, especially derived from the k-space-indexes used for the variation of the TSE-kernels (K).

8. The method according to one of the preceding claims, wherein at least one contrast-parameter, especially a repetition-time (TR) for a repetition, is determined for each TSE-kernel (K) depending on a k-space position in a partition encoding scheme,
preferably wherein a value for this contrast-parameter is defined for a center-parameterset (PC) and for an edge-parameterset (PE), preferably wherein a continuous function is used as transition-function (T) to define the contrast-parameter values, especially repetition-times (TR), between the center-parameterset (PC) and the edge-parameterset (PE).

9. The method according to claim 8, wherein the continuous function is a function of the k-space radius, especially of the Y-coordinate or Z-coordinate of k-space.

10. A device (12) for controlling an MRI-system (1), comprising:
- a kernel-unit (21) designed for providing a TSE-kernel (K) designed for Turbo Spin Echo acquisition,
- a parameter-unit (22) designed for
i) providing a center-parameterset (PC) for the TSE-kernel (K) intended for acquiring data in the center of k-space (kc), wherein the center-parameterset (PC) comprises at least timing information for the TSE-kernel (K), and
ii) providing an edge-parameterset (PE) for the TSE-kernel (K) intended for acquiring data at the edge of k-space (ke), wherein the edge-parameterset (PE) comprises at least timing information for the TSE-kernel (K),
- a transition-unit (23) designed for calculating a transition-function (T) for a continuous transition from the center-parameterset (PC) to the edge-parameterset (PE), wherein for a k-space-index according to the center of k-space (kc), the transition-function (T) corresponds to the center-parameterset (PC), for a k-space-index according to the edge of k-space (ke), the transition-function (T) corresponds to the edge-parameterset (PE) and for a k-space-index according to a k-space-position between the center of k-space (kc) and the edge of k-space (ke), the transition-function (T) is calculated based on a predefined transition-scheme,
- a sequence-unit (24) designed for generating a pulse-sequence (PS) over multiple varying k-space-indexes, wherein the TSE-kernel (K) for a certain k-space-index is varied according to the transition-function (T) depending on the k-space-index,
- a data-interface (20) designed for outputting the pulse-sequence (PS) to the MRI-system (1).

11. The device according to claim 10, comprising a filltime-unit (25) designed for inserting fill-times (TF) into the application scheme between the TSE-kernels (K) of the pulse-sequence (PS), and to determine the temporal length of the fill-times (TF) depending on the transition function (T).

12. A control-unit (13) for a magnetic resonance imaging system (1) comprising a device (12) according to claim 10 or 11 and/or designed to perform a method according to any of claims 1 to 9.

13. A magnetic resonance imaging system (1), comprising the control-unit (13) according to claim 12.

14. A computer program product comprising instructions which, when the program is executed by a computer, cause the computer to carry out the steps of the method of any of claims 1 to 9.

15. A computer-readable storage medium comprising instructions which, when executed by a computer, cause the computer to carry out the steps of the method of any of claims 1 to 9.
